Europäisches Patentamt

European Patent Office

Office européen des brevets

(19)

(11) Numéro de publication: **0 188 147**
**B1**

(12) # FASCICULE DE BREVET EUROPEEN

(45) Date de publication du fascicule du brevet:
**17.05.89**

(51) Int. Cl.⁴: **H01S 3/19**, H01L 33/00

(21) Numéro de dépôt. 85402412.2

(22) Date de dépôt: 04.12.85

(54) Procédé de fabrication d'un laser à semiconducteur à ruban enterré.

(30) Priorité: 11.12.84 FR 8418900

(43) Date de publication de la demande:
**23.07.86 Bulletin 86/30**

(45) Mention de la délivrance du brevet:
**17.05.89 Bulletin 89/20**

(84) Etats contractants désignés:
**BE DE GB LU NL**

(56) Documents cités:
**EP-A- 0 020 254**
**US-A- 3 936 322**
**US-A- 4 270 096**

**JOURNAL OF APPLIED PHYSICS,**
**vol. 45, no. 11, novembre 1974, pages 4899-4906, American Institute of Physics, New York, US; T. TSUKADA:**
**"GaAs-Ga1-xAlxAs buried-heterostructure injection lasers"**
**IEEE JOURNAL OF QUANTUM ELECTRONICS, vol. QE-15, no. 6, juin 1979, pages 451-469, IEEE, New York, US; W.T. TSANG et al.: "GaAs-AlxGa1-xAs strip buried heterostructure lasers"**

(73) Titulaire: **Menigaux, Louis, 85 avenue des Tilleuls, F-91440 Bures sur Yvette(FR)**
Titulaire: **Sansonetti, Pierre, 13, rue Baillou, F-75014 Paris(FR)**

(72) Inventeur: **Menigaux, Louis, 85 avenue des Tilleuls, F-91440 Bures sur Yvette(FR)**
Inventeur: **Sansonetti, Pierre, 13, rue Baillou, F-75014 Paris(FR)**

(74) Mandataire: **Mongrédien, André et al, c/o BREVATOME 25, rue de Ponthieu, F-75008 Paris(FR)**

**Description**

La présente invention a pour objet un procédé de fabrication d'un laser à semiconducteur à ruban enterré. Elle trouve une application en télécommunications optiques.

Le domaine technique de l'invention est celui des lasers à semiconducteurs dits à double hétérostructure et à jonction en forme de ruban. Une telle structure est constituée d'un empilement de couches semiconductrices déposées par épitaxie sur un substrat monocristallin. On trouve en général, en partant du substrat, une première couche de confinement, une couche active, une seconde couche de confinement et une couche de contact recouverte d'une couche métallique. Le caractère de double hétérostructure vient de ce que la couche active est encadrée par deux couches dont la composition est différente de celle de la couche active.

Pour les lasers émettant entre 0,8 et 0,9 µm, les couches de confinement sont en alliage $Ga_{1-x}Al_xAs$ et la couche active et le substrat sont en GaAs ; pour les lasers émettant entre 1,3 et 1,65 µm, les couches de confinement et le substrat sont en InP et la couche active en $Ga_{1-x}In_xAs_{1-y}P_y$.

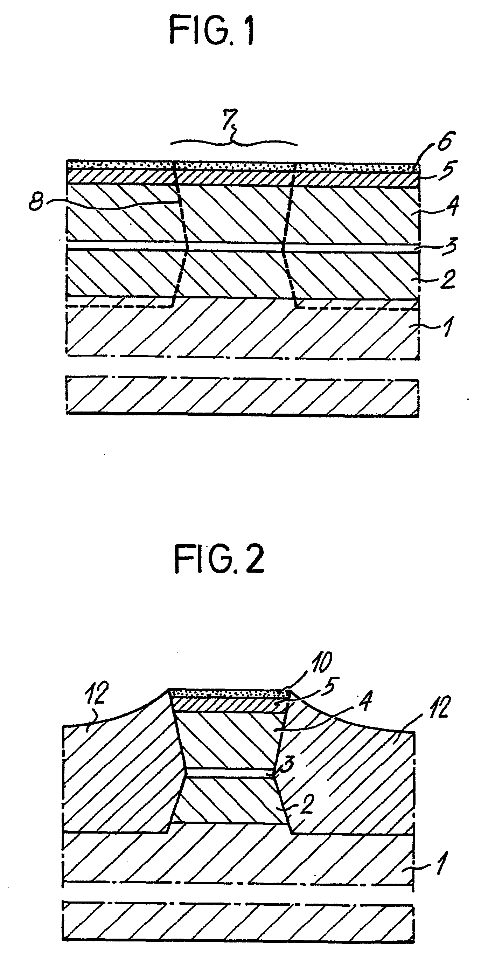

Pour faciliter le fonctionnement en continu et abaisser le courant de seuil, on a recours à une technique dite du ruban enterré (ou en abrégé "BH" pour "buried-heterostructure"). La figure 1 montre schématiquement le procédé permettant de fabriquer un tel dispositif. On commence par réaliser, par épitaxie sur un substrat 1 en GaAs de type n+ (par exemple), une double hétérostructure qui comprend une première couche de confinement 2 en $Ga_{1-x}Al_xAs$ de type N, avec x=0,3 et d'épaisseur de l'ordre de 1 µm, une couche active 3 en GaAs intentionnellement non dopée, de 0,2 µm d'épaisseur, une seconde couche de confinement 4 en $Ga_{1-x}Al_xAs$ de type P, de 1 µm d'épaisseur, et enfin une couche de contact 5 en GaAs de type p+ de 0,5 µm.

Naturellement, les composés GaAs/GaAlAs ne sont pas les seuls possibles et on peut aussi utiliser InP/InGaAsP ou d'autres composés ternaires ou quaternaires.

Une technique classiquement employée consiste ensuite à recouvrir l'ensemble avec un isolant 6, comme le nitrure de silicium ($Si_3N_4$) ou la silice ($SiO_2$). On délimite ensuite un ruban 7 par photolithographie. Une mésa est ensuite réalisée par attaque chimique au travers de ce ruban jusqu'au substrat (tirets 8). L'attaque est en général réalisée dans la direction <110> pour avoir une largeur de zone active minimale.

Pour enterrer la couche active on doit alors procéder à une recroissance de $Ga_{1-z}Al_zAs$ de type N⁻ avec z>x de telle façon que l'on ait aussi bien confinement optique qu'électrique. On peut aussi faire recroître successivement du $Ga_{1-z}Al_zAs$ de type p et ensuite de type n pour avoir une jonction bloquante. Pour cela on laisse l'isolant 7 sur la mésa, on procède à un décapage puis à une recroissance de $Ga_{1-z}Al_zAs$ généralement par épitaxie liquide ; la recroissance a alors lieu sur le substrat 1, de part et d'autre de la mésa mais pas sur l'isolant 7. Il reste ensuite à recouvrir l'ensemble d'isolant, faire des ouvertures par photolithographie et réaliser les contacts ohmiques sur la base du substrat et dans les ouvertures.

Cette technique est décrite dans un article de TSANG W.T. et LOGAN R.A. publié dans la revue "IEEE Journal of Quantum Electronics" vol. QE-15, n°6, 1979, pp 451-469.

Une autre technique consiste à ne pas utiliser de couche de contact en GaAs. Comme la croissance cristalline n'a pas lieu sur une couche de $Ga_{1-x}Al_xAs$ avec x > 0,2, on obtient encore une croissance seulement de part et d'autre de la mésa et par conséquent la même structure enterrée. Il faut cependant réaliser ensuite une diffusion locale de zinc pour avoir un bon contact ohmique sur le $Ga_{1-x}Al_xAs$.

Cette seconde technique est décrite dans l'article de T. TSUKADA publié dans la revue "Journal of Applied Physics", vol.45, n°11, Novembre 1974, pp 4899-4906.

Le problème de la première technique est lié à la difficulté d'obtention d'un isolant ($Si_3N_4$ ou $SiO_2$) qui tienne bien à la haute température qui est celle de l'épitaxie lors de la recroissance. Cette température est de l'ordre de 800°C dans le cas de GaAs.

Le problème de la deuxième technique est lié à la diffusion de zinc (généralement sous ampoule scellée) qu'il faut réaliser localement à travers des ouvertures faites dans un isolant résistant aux températures de diffusion qui sont de l'ordre de 700°C pour le GaAs.

Le but de l'invention est de simplifier le procédé de fabrication en n'utilisant ni dépôt d'isolant, ni diffusion localisée de zinc après reprise d'épitaxie.

Pour cela, on réalise, conformément à la revendication 1, d'abord une double hétérostructure selon la première technique (figure 1) mais sans déposer d'isolant 6. On procède ensuite à une implantation dans la couche de contact 5, en utilisant un dopant de type p de telle façon que la surface supérieure devienne amorphe. Cette implantation a lieu sur toute la surface de la couche. On réalise ensuite une mésa par attaque chimique au travers de rubans de résine réalisés par photolithographie. Puis on enlève la résine. On procède ensuite à la reprise d'épitaxie sur le substrat. Deux cas sont alors à distinguer :

1) Si la reprise d'épitaxie est faite en phase liquide, la recroissance n'a pas lieu sur le haut de la mésa. L'épitaxie liquide ayant lieu à haute température, on obtient en même temps un recuit de la zone implantée avec restauration de ses propriétés électriques, mais le recuit ne rend pas la couche implantée assez cristalline pour permettre une recroissance sur le haut de la mésa ; on obtient ainsi directement une couche de contact fortement dopée réalisant un excellent contact ohmique et un laser à ruban enterré.

2) Si la reprise d'épitaxie est réalisée par OMCVD ("Organo Metallic Chemical Vapor Deposition"), la recroissance est monocristalline. Cependant, sur le haut de la mésa il existe une région très disloquée entre couche implantée et couche de recroissance. Après reprise d'épitaxie, il suffit alors de faire disparaître cette couche disloquée par attaque à l'acide fluorhydrique et ultrasons. Un laser enterré est ainsi obtenu. Une technologie similaire pourrait être appliquée avec une recroissance épitaxique par jet moléculaire.

Les figures annexées permettent de mieux comprendre l'invention :

— la figure 1 déjà décrite, représente une double hétérostructure avant reprise d'épitaxie,
— la figure 2 représente la double hétérostructure à ruban enterré obtenue après mise en oeuvre du procédé selon l'invention.

Dans le cas où les composés semiconducteurs sont constitués par le couple GaAs/GaAlAs, la structure représentée sur la figure 2 comprend :

— un substrat 1 en GaAs de type $n^+$,
— une première couche épitaxiée de confinement 2 en $Ga_{1-x}Al_xAs$ de type N,
— une couche épitaxiée active 3 en GaAs intentionnellement non dopée,
— une seconde couche épitaxiée de confinement 4 en $Ga_{1-x}Al_xAs$ de type P,
— une couche de contact 5 en GaAs dopée p,
— une zone implantée 10 avec dopant de type p à la surface supérieure de la couche 5,
— une couche 12 en $Ga_{1-z}Al_zAs$ de type $n^-$ réalisée lors de la reprise d'épitaxie.

Dans le cas où la reprise d'épitaxie s'effectue en phase liquide, les demandeurs ont procédé avec succès dans les conditions suivantes : le dopant p est le zinc avec une dose de $5.10^{14}cm^{-2}$ et une énergie de 350 keV ; lors de la reprise d'épitaxie, la recroissance est réalisée avec du $Ga_{1-z}Al_zAs$ avec z=0,5. Pour une longueur de cavité de 270 µm et une largeur de zone active de 3 µm, un courant de seuil de 12 mA a été obtenu en régime impulsionnel. Les résistances de contact obtenues sont bonnes, ce qui indique que la zone implantée a bien été recuite pendant la reprise d'épitaxie liquide.

## Revendications

1. Procédé de fabrication d'un laser à semiconducteur à ruban enterré, dans lequel :
— on dépose par épitaxie, sur un substrat (1), une première couche de confinement (2) dopée N, une couche active (3) non dopée, une seconde couche de confinement (4) dopée P et une couche de contact (5), l'ensemble de ces couches formant une double hétérostructure,
— par photolithographie, on délimite un ruban (7) sur cette double hétérostructure et on procède à une attaque chimique de part et d'autre du ruban, jusqu'au substrat, ce qui laisse subsister une mésa sur le substrat,
— on effectue une reprise d'épitaxie de part et d'autre de la mésa sur les parties du substrat (2) qui ont été dégagées pour faire croître une couche semiconductrice (12) pour réaliser un confinement optique et électrique du laser,
ce procédé étant caractérisé par le fait qu'avant l'opération de photolithographie, on effectue une implantation, dans la totalité de la couche de contact (5), d'un dopant de type p, ce qui a pour effet de rendre amorphe la surface supérieure de la couche de contact (5), puis on continue le procédé par délimitation du ruban, attaque chimique et reprise d'épitaxie.
2. Procédé selon la revendication 1, caractérisé par le fait que, pour effectuer la reprise d'épitaxie, on procède par épitaxie en phase liquide, la croissance cristalline s'effectuant alors sur le substrat (1) de part et d'autre de la mésa, mais non sur la surface supérieure (10) de la couche de contact (5), qui a été implantée.
3. Procédé selon la revendication 1, caractérisé par le fait que, pour effectuer la reprise d'épitaxie, on procède par épitaxie organométallique par dépôt en phase vapeur (OMCVD), la croissance cristalline étant alors monocristalline et par le fait qu'on enlève par attaque chimique la couche de recroissance apparaissant sur le haut de la mésa.

## Patentansprüche

1. Verfahren zum Herstellen eines Halbleiterlasers mit vergrabener Streifenstruktur, bei welchem
— man auf einem Substrat (1) in einem Epitaxie-Verfahren eine N-dotierte erste Begrenzungsschicht (2), eine nicht dotierte aktive Schicht (3), eine P-dotierte zweite Begrenzungsschicht (4) und eine Kontaktschicht (5) deponiert, so daß die Schichten zusammen eine doppelte Heterostruktur bilden,
— man in einem fotolithografischen Verfahren einen Streifen (7) auf der doppelten Heterostruktur abgrenzt und beiderseits des Streifens eine chemische Ätzung bis auf das Substrat ausführt, so daß auf dem Substrat eine erhöhte Fläche zurückbleibt und
— man beiderseits der erhöhten Fläche auf den freigelegten Bereichen des Substrats (2) eine erneute Epitaxie für den Aufbau einer Halbleiterschicht (12) ausführt, um eine optische und elektrische Eingrenzung des Lasers zu schaffen, wobei das Verfahren dadurch gekennzeichnet ist, daß man vor Ausführung des fotolithografischen Verfahrens eine Implantation der gesamten Kontaktschicht (5) mit einem Dotierungsmittel des Typs P vornimmt, wodurch die freie Oberfläche der Kontaktschicht (5) amorph wird, und daß man anschließend das Verfahren durch Begrenzung des Streifens, chemisches Ätzen und erneute Epitaxie fortführt.
2. Verfahren nach Anspruch 1, dadurch gekennzeichnet, daß man bei erneuter Aufnahme der Epitaxie eine Epitaxie in flüssiger Phase durchführt, wobei das kristalline Wachstum dann beiderseits der erhöhten Fläche auf dem Substrat (1) erfolgt, nicht jedoch auf der freien Oberfläche (10) der Kontaktschicht (5), an welcher die Implantation vorgenommen wurde.
3. Verfahren nach Anspruch 1, dadurch gekennzeichnet, daß man bei erneuter Aufnahme der Epitaxie eine organo-metallische Epitaxie durch Niederschlag in dampfförmiger Phase (OMCVD) durchführt, wobei das kristalline Wachstum dann monokristallin ist, und daß man die sich auf der freien Oberfläche der erhöhten Fläche erscheinende Wachstumsschicht durch chemisches Ätzen entfernt.

## Claims

1. Process for manufacturing a semiconductor laser having a buried ribbon, in which:

– on a substrate (1), there is deposited by epitaxy a first N-doped confinement layer (2), a non-doped active layer (3), a second P-doped confinement layer (4) and a contact layer (5), the group of these layers forming a double heterostructure,

– by photolithography, a ribbon (7) is delimited on this double heterostructure and an etching on both sides of the ribbon is performed, to the substrate, which allows a mesa to remain on the substrate,

– a resumption of epitaxy is performed on both sides of the mesa on the parts of the substrate (2) which have been released to cause a semiconductive layer (12) to grow to achieve an optical and electrical confinement of the laser, this process being characterized by the fact that before the photolithography operation, an implantation of a p-type doping material is performed in the entire contact layer (5), which has the effect of rendering the upper surface of the contact layer (5) amorphous, then the process is continued by delimiting the ribbon, etching and resumption of epitaxy.

2. Process according to claim 1, characterized in that to perform the resumption of epitaxy, epitaxy in liquid phase is undertaken the crystalline growth then being performed on the substrate (1) on both sides of the mesa, but not on the upper surface (10) of the contact layer (5), which was implanted.

3. Process according to claim 1, characterized in that to perform the resumption of epitaxy, epitaxy by organometallic chemical vapor deposition (OMCVD) is undertaken, the crystalline growth then being monocrystalline and wherein the growth layer that appears on the top of the mesa is removed by etching.

# FIG. 1

# FIG. 2